# EUROPEAN PATENT APPLICATION

(11) **EP 3 068 203 A1**
(43) Date of publication of application: **14.09.2016**
(21) Application number: 15305371.5
(22) Date of filing: 12.03.2015
(51) Int. Cl.: H05K 7/20, F23L 17/02, F23L 17/06, H02B 7/08, H02G 9/10

(54) **A cooling system, a method for cooling and an electronic apparatus**

(71) Applicant: ALCATEL LUCENT, 92100 Boulogne-Billancourt (FR)
(72) Inventor: Frizzell, Ronan, Dublin, 15 (IE); Donnelly, Brian, Dublin, 15 (IE); Jeffers, Nick, Blanchardstown, Dublin 15 (IE)
(74) Representative: Bryers LLP

(57) **Abstract**

A cooling system for a subterranean electronic apparatus, the system comprising an air inlet at or above ground level to receive environmental air at an ambient temperature for the system, an air outlet at or above ground level to exhaust heated air from the system, and a subterranean conduit between the inlet and the outlet configured to allow air drawn into the conduit at the inlet to flow towards the outlet, at least a portion of the conduit passing in close proximity to or otherwise in contact with or coupled to the electronic apparatus to be cooled, wherein the air outlet comprises a structure configured to induce airflow between the inlet and the outlet and through the subterranean conduit.

## Description

### TECHNICAL FIELD

Aspects relate, in general, to a cooling system and a method for cooling an underground electronic apparatus.

### BACKGROUND

Future deployment of next generation telecommunications infrastructures aims to bring fibre as close to the end user as possible. Current fixed access devices are typically placed in cavities beneath ground level such as in man-holes or even smaller hand-holes before being split to multiple end users. For example, an electronic apparatus such as a router that receives a broadband signal from a fibre-based infrastructure can be used to split off a broadband signal for multiple end users over traditional cabling, such as copper cabling for example. The current method of deployment involves digging a hole and building or inserting a structure into the hole. This could be a concrete enclosure or a moulded plastic structure. Both have access through a surface opening that can be sealed closed.

Next generation deployment is anticipated to take place directly in the ground outside each and every home with a single unit serving a single home. This means that devices could be deployed to an entire housing estate without the need to enter private property. The connection to the home is made and a subscriber upgrades to the high bandwidth provided by such a device when they are ready. An example of such a technology is a telecoms node or broadband router device which can provide fibre speeds over relatively short lengths of copper wires, hence the deployment close to individual homes. In such deployment, the electronic apparatus used to provide services, such as broadband, will likely be buried beneath ground in a small hole directly in the soil.

### SUMMARY

According to an example, there is provided a cooling system for a subterranean electronic apparatus, the system comprising an air inlet at or above ground level to receive environmental air at an ambient temperature for the system, an air outlet at or above ground level to exhaust heated air from the system, and a subterranean conduit between the inlet and the outlet configured to allow air drawn into the conduit at the inlet to flow towards the outlet, at least a portion of the conduit passing in close proximity to or otherwise in contact with or coupled to the electronic apparatus to be cooled, wherein the air outlet comprises a structure configured to induce airflow between the inlet and the outlet and through the subterranean conduit. The structure configured to induce airflow can include a cover with an upper surface operable to receive sunlight whereby to heat air at the air outlet of the system so as to provoke airflow from the inlet to the outlet. The cover can be an air-permeable cover comprising a mesh or lattice section through which air may pass. An outer part of the cover can be black or darkened or blackened so as to maximize absorption of solar radiation. The structure can be configured to induce airflow includes a conduit to receive an external airflow therethrough whereby to induce airflow from the inlet to the outlet. At least a portion of the subterranean conduit can be composed of a porous material. The porous material can be a sintered metal operable, by way of capillary effect, to enable moisture to wick or be drawn into the conduit. The subterranean conduit can be a cabling conduit arranged to carry communication and power cables.

According to an example, there is provided a method for cooling a subterranean electronic apparatus, the method including inducing an airflow in a subterranean conduit, at least a portion of the conduit passing in close proximity to or otherwise in contact with or coupled to the electronic apparatus to be cooled, from an air inlet of the conduit at or above ground of the conduit to an air outlet of the conduit at or above ground level using a structure configured to induce airflow at the air outlet. The structure configured to induce airflow at the air outlet can include an air-permeable cover with an upper surface operable to receive sunlight, the method including exposing the upper surface to solar radiation whereby to heat air at the air outlet of the system so as to entrain or induce an airflow from the inlet to the outlet. The structure configured to induce airflow at the air outlet can include a conduit to receive an external airflow therethrough, the method including exposing the conduit to the external environment whereby to entrain or induce an airflow from the inlet to the outlet. The method can further include cooling the airflow in the subterranean conduit by providing moisture in the subterranean conduit to be evaporated by the airflow.

According to an example, there is provided an electronic apparatus for deployment beneath the ground and which is operable to generate heat during operation, wherein the apparatus is configured to be positioned in close proximity to or otherwise in contact with or coupled to a conduit of a cooling system as provided herein. The apparatus can be configured to be coupled with the conduit using openings of the apparatus to establish a route through the apparatus for an airflow from a conduit of the cooling system. The position of the openings can be selected to maximize the flow of air over and around internal components of the apparatus.

### BRIEF DESCRIPTION OF THE DRAWINGS

Embodiments will now be described, by way of example only, with reference to the accompanying drawings, in which:
Figure 1 is a schematic representation of a cooling system according to an example;
Figure 2 is a schematic representation of a cooling system according to an example;
Figure 3 is a schematic representation of a cooling system according to an example; and
Figure 4 is a schematic representation of an electronic apparatus according to an example.

### DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

Deployment of electronic apparatus used to provide services, such as broadband, directly in the soil beneath ground differs greatly from the current use of man/hand holes as there is no longer air surrounding the product. The lack of air makes heat dissipation from the product extremely challenging.

Thermal management solutions for existing devices allow for the thermal load from an electronic apparatus to be dissipated into convecting air, however, this is not possible with the proposed subterranean method of deployment. This means the only mode of heat transport is conduction through/to the soil, which is problematic since soil has a poor thermal conductivity, and hence, poor heat removal capability.

According to an example, solar and wind driven airflow can be used in order to cool underground deployments of products such as electronic apparatus, which may generate heat. A cooling system according to an example can cause airflow from the surface to travel through a tube or conduit and circulate past or within the heat producing product or apparatus to cool it before being ejected or flowing out of the conduit. In an example, the conduit can allow moisture from the soil to be absorbed by the drier ambient air that enters the conduit from an inlet, which causes the air to reduce in temperature thereby further increasing the cooling effect of the system. The lower temperature air cools the apparatus as it flows past or within it, and the heat taken from the product is rejected or exhausted to the atmosphere when the air flow reaches the outlet of the system. This requires no moving parts or power consumption.

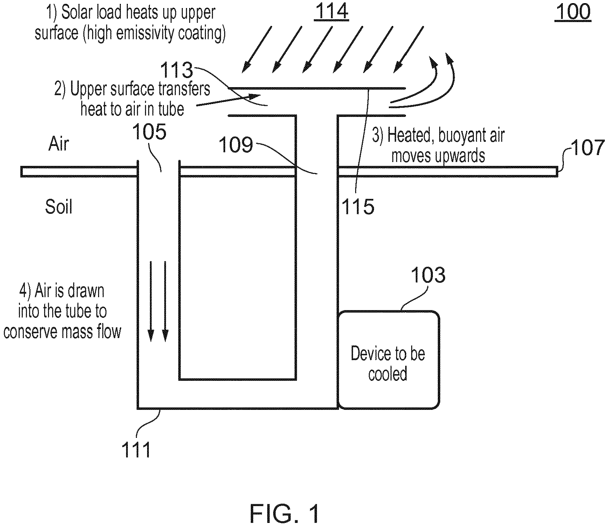

Figure 1 is a schematic representation of a cooling system according to an example. A net airflow for the system is caused by thermal updraft caused by solar loading on a section of an air outlet of the system forming an outlet structure configured to induce airflow between an inlet and the outlet and through a subterranean conduit. That is, as shown in figure 1, a cooling system 100 for a subterranean electronic apparatus 103 includes an air inlet 105 at or above ground level 107 to receive environmental air at an ambient temperature for the system, and an air outlet 109 at or above ground level 107 to exhaust heated air from the system by allowing the heated air to flow to external environment. A subterranean conduit 111 between the inlet 105 and the outlet 109 and through which air drawn in at the inlet 105 can flow towards the outlet 109 is provided. In an example, at least a portion of the conduit 111 passes in close proximity to or is otherwise in contact with or coupled to the electronic apparatus 103 to be cooled. In an example, the portion of the conduit 111 may be an integral part of the casing of the apparatus 103, whereby to enable cool air to flow over one or more surfaces of the apparatus, or to be received and circulate internally in the apparatus, before flowing towards the outlet 109.

In the example of figure 1, the outlet 109 includes an outlet structure in the form of a cover 113 to receive an external airflow or intake of air. In the example of figure 1, the cover 113 is in the form of a conduit or a plate with a channel in fluid communication with the outlet 109, and that is arranged substantially horizontally, but which may be oriented in any desired way. Solar loading of the top surface or portion of the cover 113 heats the upper surface 115 or the surface that is otherwise exposed to the sun, as depicted by lines 114. In the example of figure 1, the heated upper surface transfer heat into the conduit 113 which heats the air therein. As this heated air is more buoyant than the air outside of the conduit 113, it moves out of the conduit 113 and moves upwards. To conserve mass flow, the movement of heated air from conduit 113 thus induces an airflow in the conduit by drawing air into inlet 105, which in the example of figure 1 is remotely located from the air outlet 109. The air that is drawn in is ambient air, which moves through the conduit 111 and thus circulates past the apparatus 103 causing it to be cooled.

The cover 113 forming the outlet structure may be, for example, a man-hole cover or similar. That is, the cover may be arranged to over the outlet 109 at ground level. In such a case, the cover can include openings in order to enable heated air to escape from the outlet 109.

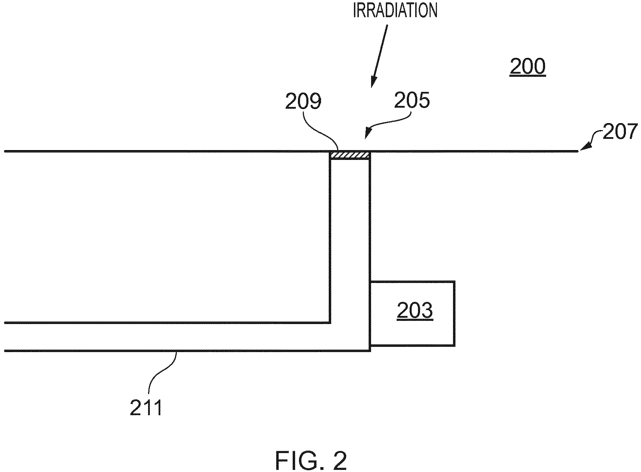

Figure 2 is a schematic representation of a system according to an example. Similarly to the system of figure 1, a net airflow for the system is caused by thermal updraft caused by solar loading on a section of an air outlet of the system forming an outlet structure configured to induce airflow between inlet and outlet and through a subterranean conduit. That is, as shown in figure 2, a cooling system 200 for a subterranean electronic apparatus 203 includes an air outlet 205 at or above ground level 207 to exhaust heated air from the system by allowing heated air to flow to the external environment. A subterranean conduit 211 is depicted. In the example of figure 2, an existing cabling architecture is used to provide the system.

Generally, in these ground deployments there is a series of pipes that are used to carry communication and power cables (not shown) to the device 203. These pipes are normally buried between 1-2m below the earth's surface, at which depths the soil temperature approaches 20C regardless of the external ambient air temperature (i.e. temperature swings during the day and night have little effect on soil at this depth).

These pipes are typically much larger in cross-section than the cables that are in them to allow the cables to be fed through by the installer. In the example of figure 2, the fact that there is an existing pipe architecture connecting to the device 203 being cooled is taken advantage of.

More particularly, an outlet structure in the form of cover 209, such as a manhole cover for example can have a structure embedded into it, such as a honeycomb structure for example, which can maximize the area over which IR light from the sun is absorbed. In an example, all surfaces facing the sun can be matt black in colour to simulate a black body and absorb the sun's radiation, while surfaces facing in the other direction can be polished silver to minimise radiation. A honeycomb structure can maximize the volume of air heated by IR radiation from the sun at any given time therefore enhancing the buoyancy force of heated air through the manhole cover. These forces pull cool air through the existing pipe cable architecture 211 over the product 203 and out through the manhole cover 209. The hotter the manhole cover gets the more air is pulled through it.

Accordingly, the movement of heated air at an outlet of the system causes an airflow within the subterranean conduit by inducing relatively cooler air to enter the system and flow through the conduit 111, 211. In the case of figure 2 for example, air can enter the system from any number of locations that are upstream of the outlet 205, such as from small gaps in the existing architecture at or above ground level for example, and/or from one or more inlets for the system (not shown in the example of figure 2). Thus, an inlet for the system can be a standalone inlet, or can be any other opening through which air can flow or be drawn in.

As air flows through a conduit 111, 211, it can evaporate moisture from the surrounding soil that has permeated into the conduit, thereby causing the temperature of the air to reduce further. To facilitate moisture ingress from the soil, at least a portion of the conduit can be permeable or porous. For example, the portion may have holes in, or may be formed from a sintered material, such as sintered copper for example. The holes, voids and channels through such a material can cause moisture to wick or otherwise be drawn into the conduit, such as by way of capillary effect for example.

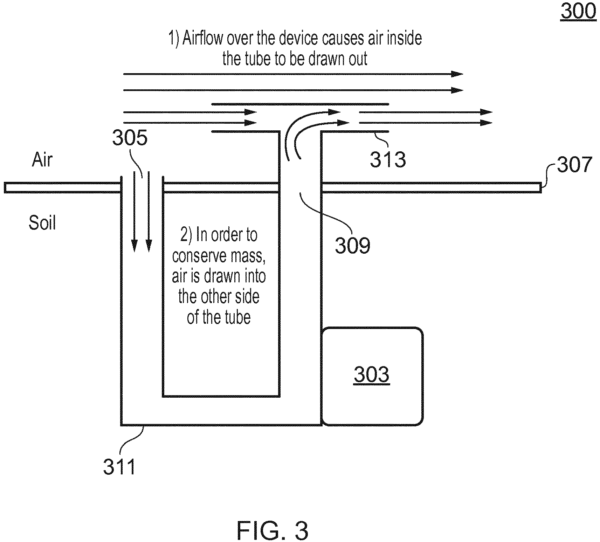

Figure 3 is a schematic representation of a cooling system according to an example. Similarly to the system of figure 1, the cooling system 300 for a subterranean electronic apparatus 303 includes an air inlet 305 at or above ground level 307 to receive environmental air at an ambient temperature for the system, and an air outlet 309 at or above ground level 307 to exhaust heated air from the system by allowing the heated air to flow to external environment. A subterranean conduit 311 between the inlet 305 and the outlet 309 and through which air entrained at the inlet 305 can flow towards the outlet 309 is provided. In an example, at least a portion of the conduit 311 passes in close proximity to or is otherwise in contact with or coupled to the electronic apparatus 303 to be cooled. In an example, the portion of the conduit 311 may be an integral part of the casing of the apparatus 303, whereby to enable cool air to flow over one or more surfaces of the apparatus, or to be received and circulate internally in the apparatus, before flowing towards the outlet 309.

In the example of figure 3, the outlet 309 includes an outlet structure in the form of a conduit 313. Environmental airflow past the conduit 311 induces air inside the conduit 311 to be drawn out, thereby entraining air from within conduit 311 so as to cause an airflow from the inlet 305 to outlet 309. That is, as environmental air flows past and through the conduit 313, air within the conduit 311 begins to flow. In a similar manner to the examples described above, this airflow is generated by virtue of the Bernoulli principle, since air moving at an increased velocity exists at a lower pressure. The high velocity/low pressure environmental air causes air in the outlet 309 to flow into conduit 313. To conserve mass flow, air is drawn into inlet 305, and thus a cooling airflow past the apparatus 303 is provided, which may be augmented as moisture in the conduit evaporates. Accordingly, a portion or more of the conduit 311 may be porous or permeable, such as described above. Similar considerations apply to the system described above with reference to figures 1 and 2.

An apparatus can include an opening to the inside of the apparatus through which air from the conduit can flow. For example, air from the conduit can flow into the apparatus and circulate before exiting through either the same of another opening in the apparatus. That is, the internal structure of the apparatus may be such as to define a route via which air can flow from a first opening and circulate before passing to a second opening (upstream in terms of the direction of the airflow for the system) where it is ejected back into the conduit and can thus pass to the outlet of the system.

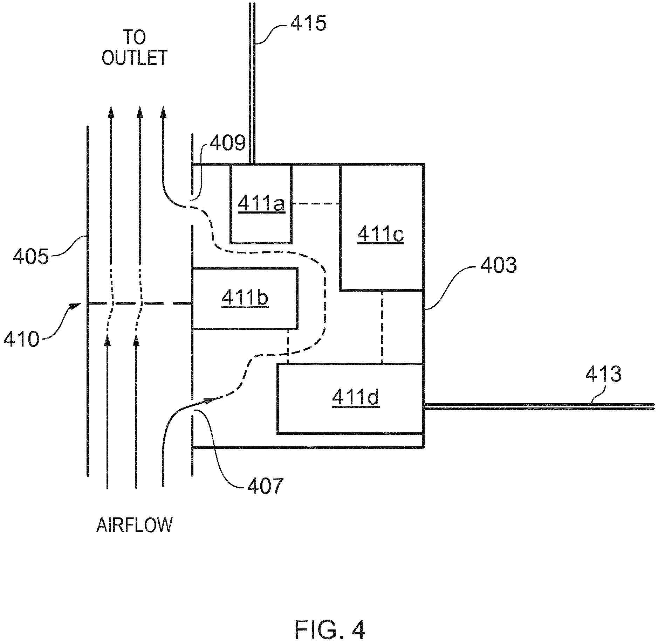

Figure 4 is a schematic representation of an electronic apparatus according to an example. The apparatus 403 includes two openings to a coupled conduit 405 of a cooling system (not shown in its entirety in this figure); an inlet opening 407 and an outlet opening 409. An airflow within conduit 405, which flows as explained above with reference to figures 1 to 3, passes through conduit 405 towards an outlet of the cooling system. A baffle 410 can be provided in conduit 405 between the openings 407, 409. The baffle may be extend across the conduit and may include some openings so as not to completely restrict the flow of air directly through the conduit. Nevertheless, the provision of such a baffle, which interrupts airflow in the conduit, causes some (or all in the case that the baffle does not have any holes or openings) air to pass into inlet opening 407 where it flow through the apparatus 403 to outlet opening 409 to rejoin the main air flow towards the outlet of the system. As the air circulates through the apparatus it cools the components 411a-d of the apparatus (more or less may be provided as will be appreciated). The openings may be positioned with knowledge of the internal positioning of component of apparatus 403 so as to enable the air flow within to take a circuitous route that passes as many components as possible. Such a positioning is broadly shown in figure 4.

Alternatively, the provision of an airflow within the apparatus, even if that air flow does not reach all components or the extremities of the inside of the apparatus may be sufficient. Apparatus 403 as depicted includes an input 413 to send/receive data and communications and an output 415 (which can pass to a house for example), to send/receive data. For example, input 413 can be a fibre cable input for broadband services, and output 415 can be a copper cable (or similar).

Thus, according to an example, air is drawn into an inlet of the system and travels through a conduit, which can be a dedicated conduit or part of a larger architecture, such as a conduit for pipework and cabling and so on. As the air travels along the tube, porous wall can allow moisture from the soil to penetrate into the conduit where it can evaporate by action of the airflow in the conduit. This evaporation causes the air temperature to reduce and the cooler air then travels over the product to be cooled through, for example, a thermally conductive section of the pipe. Heat is absorbed by the air and this is then ejected to the ambient air above the surface at the other end (outlet). Although reference is made herein to an electronic apparatus it will be appreciated that a cooling system as described herein may be used with mechanical apparatus as well.

The present inventions can be embodied in other specific apparatus and/or methods. The described embodiments are to be considered in all respects as illustrative and not restrictive. In particular, the scope of the invention is indicated by the appended claims rather than by the description and figures herein. All changes that come within the meaning and range of equivalency of the claims are to be embraced within their scope.

## Claims

1. A cooling system for a subterranean electronic apparatus, the system comprising:
an air inlet at or above ground level to receive environmental air at an ambient temperature for the system;
an air outlet at or above ground level to exhaust heated air from the system; and
a subterranean conduit between the inlet and the outlet configured to allow air drawn into the conduit at the inlet to flow towards the outlet, at least a portion of the conduit passing in close proximity to or otherwise in contact with or coupled to the electronic apparatus to be cooled;
wherein the air outlet comprises a structure configured to induce airflow between the inlet and the outlet and through the subterranean conduit.

2. A cooling system as claimed in claim 1, wherein the structure configured to induce airflow includes a cover with an upper surface operable to receive sunlight whereby to heat air at the air outlet of the system so as to provoke airflow from the inlet to the outlet.

3. A cooling system as claimed in claim 2, wherein the cover is an air-permeable cover comprising a mesh or lattice section through which air may pass.

4. A cooling system as claimed in claim 2 or 3, wherein an outer part of the cover is black or darkened or blackened so as to maximize absorption of solar radiation.

5. A cooling system as claimed in any preceding claim, wherein the structure configured to induce airflow includes a conduit to receive an external airflow therethrough whereby to induce airflow from the inlet to the outlet.

6. A cooling system as claimed in any preceding claim, wherein at least a portion of the subterranean conduit is composed of a porous material.

7. A cooling system as claimed in claim 6, wherein the porous material is a sintered metal operable, by way of capillary effect, to enable moisture to wick or be drawn into the conduit.

8. A cooling system as claimed in any preceding claim, wherein the subterranean conduit is a cabling conduit arranged to carry communication and power cables.

9. A method for cooling a subterranean electronic apparatus, the method including:
inducing an airflow in a subterranean conduit, at least a portion of the conduit passing in close proximity to or otherwise in contact with or coupled to the electronic apparatus to be cooled, from an air inlet of the conduit at or above ground of the conduit to an air outlet of the conduit at or above ground level using a structure configured to induce airflow at the air outlet.

10. A method as claimed in claim 9, wherein the structure configured to induce airflow at the air outlet includes an air-permeable cover with an upper surface operable to receive sunlight, the method including exposing the upper surface to solar radiation whereby to heat air at the air outlet of the system so as to entrain or induce an airflow from the inlet to the outlet.

11. A method as claimed in claim 9, wherein the structure configured to induce airflow at the air outlet includes a conduit to receive an external airflow therethrough, the method including exposing the conduit to the external environment whereby to entrain or induce an airflow from the inlet to the outlet.

12. A method as claimed in any of claims 9 to 11, further including:
cooling the airflow in the subterranean conduit by providing moisture in the subterranean conduit to be evaporated by the airflow.

13. An electronic apparatus for deployment beneath the ground and which is operable to generate heat during operation, wherein the apparatus is configured to be positioned in close proximity to or otherwise in contact with or coupled to a conduit of a cooling system as claimed in any of claims 1 to 8.

14. An electronic apparatus as claimed in claim 13, wherein the apparatus is configured to be coupled with the conduit using openings of the apparatus to establish a route through the apparatus for an airflow from a conduit of the cooling system.

15. An electronic apparatus as claimed in claim 14, wherein the position of the openings is selected to maximize the flow of air over and around internal components of the apparatus.
